# EUROPÄISCHE PATENTSCHRIFT

(11) **EP 3 658 927 B1**
(45) Veröffentlichungstag und Bekanntmachung des Hinweises auf die Patenterteilung: **09.04.2025**
(21) Anmeldenummer: 18779289.0
(22) Anmeldetag: 19.09.2018
(51) Int. Cl.: G01R 31/12

(54) **VERFAHREN UND KOMBINATION ZUM ERKENNEN VON TEILENTLADUNGEN BEI EINEM ELEKTRISCHEN BETRIEBSMITTEL**
METHOD AND COMBINATION FOR DETECTING PARTIAL DISCHARGES OF AN ELECTRICAL OPERATING DEVICE
PROCÉDÉ ET COMBINAISON PERMETTANT D'IDENTIFIER DES DÉCHARGES PARTIELLES SUR UN ÉQUIPEMENT ÉLECTRIQUE

(30) Priorität: 26.09.2017 DE 102017217127
(43) Veröffentlichungstag der Anmeldung: 03.06.2020
(73) Patentinhaber: Siemens Energy Global GmbH & Co. KG, 81739 München (DE)
(72) Erfinder: WIEDENBAUER, Anton, 91809 Wellheim (DE)
(86) Internationale Anmeldenummer: PCT/EP2018/075268
(87) Internationale Veröffentlichungsnummer: WO 2019/063367

(56) Entgegenhaltungen:
- WO-A1-92/06385
- US-A1- 2002 163 344
- US-A1- 2015 355 256
- US-A1- 2016 274 176

## Beschreibung

Verfahren und Kombination zum Erkennen von Teilentladungen bei einem elektrischen Betriebsmittel Die Erfindung betrifft ein Verfahren gemäß dem Oberbegriff des Anspruchs 1 sowie eine Kombination gemäß dem Oberbegriff des Anspruchs 8.

Gasisolierten Schaltanlagen sind aus der Produktbroschüre "Gasisolierte Schaltanlagen, Baureihe 8DN8 bis 170 kV, 63 kA, 4000 A" der Siemens AG, 2011, Bestell-Nr. E50001-G620-A122-V1 bekannt. Bei einer Zustandsüberwachung von gasisolierten Schaltanlagen (GIS) liegt das Hauptaugenmerk auf der Erkennung van Teilentladungen (TE), da diese bei den meisten Fehlerszenarien auftreten. Das Mittel der Wahl ist die Detektion der TE mittels Messung elektromagnetischer (EM) Wellen, die sich bei jeder TE in der GIS ausbreiten. Diese werden typischerweise im Ultrahochfrequenzbereich (UHF Bereich) erfasst, der sich von einigen hundert MHZ bis wenigen GHz im Frequenzspektrum befindet.

Im Falle einer TE treten elektromagnetische Impulse typischerweise mehrfach pro Sinuswelle (der Netzspannung, z.B. 50Hz) auf. Diese Impulse sind breitbandig, werden aber durch die GIS bauartbedingt in einigen Frequenzbereichen mehr gedämpft als in anderen. Der ideale Frequenzbereich zur Erfassung von TE variiert daher für GIS unterschiedlichen Typs. Ein Verfahren zur Zustandsüberwachung muss TE sicher erfassen und deswegen sensitiv genug sein, die elektromagnetischen Impulse der zu überwachenden GIS erfassen zu können. Um dies sicher zu stellen, wird das System bei Inbetriebnahme mittels eines sog. Kalibrators eingestellt. Der Kalibrator kann einen elektromagnetischen Referenz-Impuls bereit stellen, um das Verfahren bzw. die entsprechende Anordnung zum Erkennen von Teilentladungen zu kalibrieren.

Zum Beispiel betrifft die US 2002/163344 A1 ein Diagnosesystem für eine isolierte Vorrichtung.

US 2016/274176 A1 offenbart ein System zur Erfassung von Teilentladungen.

Ein typisches Setup eines UHF TE Monitoring Systems besteht aus Filterkomponenten, einer Signalverstärkung und einem Analog-Digital-Wandler, der schnell und präzise ein 12 Bit Signal erzeugen kann. Ferner wird eine Störsignalfilterung und eine Fehlerursachenerkennung nach dem sog. Point-on-Wave Analyseverfahren durchgeführt. Es werden zusätzlich eine Datenspeicherung, eine Visualisierung und Kommunikationsprotokolle benötigt. Die zugrundeliegende Hard- und Software wird teilweise bis zu sechsmal pro Feld eingesetzt. Dies ergibt sich daraus, dass z.B. bei einer dreiphasigen Ausführung einer GIS für jede Phase jeweils vor und nach einem Leistungsschalter eine Messeinrichtung für TE benötigt wird. Das Resultat des bisherigen Ansatzes sind komplexe und teure Systeme, die für technische Experten eine direkte Analyse der Fehlerursache und Fehlerschwere erlauben. Beispielsweise ist ein digitales Zustandsüberwachungssystem für GIS unter dem Markennamen "Assetguard PDM" aus der Produktbroschüre "Assetguard Switchgear Condition Monitoring - Integriertes Substation Condition Monitoring (ISCM^{®}) für HS-Schaltanlagen", Siemens AG 2012, Auftragsnr.: IC1000-G240-A100-X-4A00, bekannt. Auch aus der Dissertation "Teilentladungsmessung im Gigahertz-Frequenzbereich an SF6-isolierten Schaltanlagen" von Rolf Kurrer aus dem Jahr 1997, Institut für Energieübertragung und Hochspannungstechnik der Universität Stuttgart, ISBN 3-8265-2211-7, sind Verfahren zur Auswertung von UHF-Signalen für eine Erkennung von Teilentladungen in GIS bekannt.

Es wird bei bekannten Verfahren häufig ein sogenanntes Phase-Resolved-Partial-Discharge (PRPD) Diagramm ausgewertet, da dieses Rückschlüsse auf die Ursache einer Teilentladung ermöglicht. Für ein PRPD Diagramm wird das erkannte Teilentladungssignal einem Sinussignal für eine Primärspannung, also die an der gasisolierten Schaltanlage anliegende und zu schaltende Spannung, überlagert. Das durch UHF Antennen erfasste TE-Signal selbst erlaubt keinen Rückschluss darüber, an welcher Phase der Sinuswelle sie auftrat. Durch die Überlagerung im PRPD Diagramm wird ein Teilentladungsereignis einer Phasenposition als sog. Point-on-Wave (PoW) Information zugeordnet. Diese Phaseninformation erlaubt es, Vermutungen über die Ursache eine Teilentladung anzustellen, weil Teilentladungen in der GIS i.d.R. zu bestimmten Zeiten im Phasenverlauf ausgelöst werden.

Ein typisches Setup eines UHF TE Monitoring Systems sieht dezentrale Erfassungseinheiten vor, um die Kabelverbindungslänge zwischen Antenne und Erfassungseinheit gering zu halten (typischerweise kleiner als 10m). Andernfalls wäre eine Dämpfung der empfangenen UHF-Signale zu hoch. Um eine Point-on-Wave Auswertung zu realisieren wird i.d.R für jede dezentrale Erfassungseinheit der Verlauf einer Sinuswelle an der GIS separat erfasst. Bei dem o.g. System Assetguard wird beispielsweise die Sinuswelle jeweils aus der Spannungsversorgung des TE Monitoring Systems bestimmt.

Ausgehend von dem bisher bekannten Verfahren zum Erkennen von Teilentladungen bei einem elektrischen Betriebsmittel mittels UHF Auswertung stellt sich an die Erfindung die Aufgabe, ein Verfahren anzugeben, das vergleichsweise einfach und kostengünstig ist.

Die Erfindung löst diese Aufgabe durch ein Verfahren gemäß Anspruch 1.

Als Spannungsmessanordnung kann beispielsweise eine bekannte Phasormesseinrichtung verwendet werden. Die Referenzanordnung und die Zeitstempelanordnung können beispielsweise mit jeweils einem digitalen Signalprozessor sowie entsprechender Software umgesetzt werden. Auch die Auswertungsanordnung kann mit üblichen Rechnermitteln wie etwa einem digitalen Signalprozessor oder einem Computer umgesetzt werden.

Kernpunkt des erfindungsgemäßen Verfahrens ist es, die am Betriebsmittel anliegende Spannung nur einmal zentral zu erfassen anstatt n-mal dezentral. Die zentrale Komponente verfügt dafür - ebenso wie die dezentralen Bauteile - über eine interne Zeitreferenz, die mit einem externen Zeitserver synchronisiert ist.

Dies ergibt die Möglichkeit, die gemessene Referenzspannung und die dezentral erfassten Impulse für eine spätere Auswertung mit Zeitstempeln zu versehen. Basierend auf der internen Zeitreferenz werden mit geeigneten messtechnischen Mitteln charakteristische Punkte der Sinuswelle bestimmt, z.B. Zeitpunkte der Nulldurchgänge bei positiver Flanke (tO, t1, ... tn). Unter Berücksichtigung etwaiger Totzeiten oder Verzögerungen bei der Erfassung eines elektromagnetischen Impulses bzw. einer Teilentladung kann das resultierende TE-Messergebnis mit der zentral gemessenen Sinuswelle überlagert werden.

Im Gegensatz zu bisherigen Verfahren zur Erfassung von Teilentladungen erfolgt also eine zentrale Messung der Referenzspannung(en) und eine dezentrale Überlagerung der TE-Messung(en) mit der Referenzspannung, wobei jede Information digital und paketorientiert ausgetauscht wird. Die Systemkomponenten werden hierbei untereinander, aber prinzipiell auch nach extern zeitlich synchronisiert.

Es ergibt sich eine Reihe von Vorteilen. Es steht nicht immer eine ausreichende Anzahl Spannungswandler zur Verfügung, um alle dezentralen Komponenten mit der Sinusinformation aus den Spannungswandlern zu versorgen. Bekannte Alternativen zur Messung am Spannungswandler wie etwa eine Messung an der Spannungsversorgung oder eine Messung einer Flackerfrequenz von Leuchtstoffröhren sind ungenau im Hinblick auf das tatsächliche Sinussignal wie auch im Hinblick auf die Synchronisation untereinander.

Erfindungsgemäß kann ein bereits vorhandener Kommunikationskanal verwendet werden, was eine zusätzliche Verdrahtung erübrigt und Kosten einspart.

In einer bevorzugten Ausführungsform des erfindungsgemäßen Verfahrens wird anhand der Zeitstempel der Teilentladungssignale ein Zusammenhang mit Ereignissen, die an dem Betriebsmittel auftreten, hergestellt. Die Ereignisse müssen entsprechend ebenfalls mit Zeitstempeln versehen sein, die eine zeitliche Synchronisation erlauben.

In einer bevorzugten Weiterbildung dieser Ausführungsform umfassen die Ereignisse mindestens eines der folgenden Ereignisse: Schutzereignisse, Spannungsüberhöhungen, Schaltereignisse. Die Ausbildung eines Lichtbogens - und dessen Dauer - infolge eines Schaltereignisses wird häufig als "Arcing Time" bezeichnet. Dabei handelt es sich um die Zeit bis zum Erlöschen eines Lichtbogens innerhalb einer GIS. Ein solcher Lichtbogen tritt bei Schaltvorgängen auf, wobei die Dauer des Lichtbogens einen Hinweis auf Fehler in der GIS gibt. Schutzereignisse können beispielsweise durch eine Überlagerung der Teilentladung mit sog. "Comtrade Files" erkannt werden.

In einer bevorzugten Ausführungsform des erfindungsgemäßen Verfahrens werden als Sensoreinrichtungen interne und/oder externe Antennen zum Empfang von elektromagnetischen Signalen verwendet. Die intern und extern empfangenen UHF Signale werden jeweils in gleicher, erfindungsgemäßer Weise ausgewertet. Kommt ein mittels einer internen Antenne erkanntes TE-Signal auch in den empfangenen UHF Signalen einer zugeordneten externen Antenne vor, so handelt es sich um eine von außen einwirkende Störung und nicht um eine in der GIS vorkommende TE. Ein solches als äußere Störeinwirkung erkanntes Signal wird folglich nicht als Teilentladung gewertet und bei einer weiteren Auswertung nicht berücksichtigt.

In dem erfindungsgemäßen Verfahren wird als Betriebsmittel eine gasisolierte elektrische Schaltanlage verwendet. Dies ist ein Vorteil, weil Teilentladungen häufig bei GIS vorkommen können und dort auf Fehler im Gerät hinweisen. Heutige GIS sollten im Normalbetrieb keine Teilentladungen produzieren.

In dem erfindungsgemäßen Verfahren wird die elektrische Spannung zentral an einem Spannungswandler für das Betriebsmittel erfasst. Dies ist ein Vorteil, weil am Spanungswandler besonders einfach der Spannungsverlauf für das angeschlossene Betriebsmittel gemessen werden kann.

In einer weiteren bevorzugten Ausführungsform des erfindungsgemäßen Verfahrens wird die Überlagerung jeweils ausgewertet, um eine Ursache der jeweiligen Teilentladung zu erkennen. Dies ist ein Vorteil, weil die Überlagerung von sinusförmigem Spannungsverlauf mit der erkannten Teilentladung es ermöglicht, auf Ursachen der Teilentladung zurück zu schließen. Die Auswertung bzw. Interpretation der Überlagerung kann maschinell oder durch einen Techniker erfolgen.

In einer weiteren bevorzugten Ausführungsform des erfindungsgemäßen Verfahrens wird für die Überlagerung jeweils ein Point-on-Wave Verfahren eingesetzt. Dies ist ein Vorteil, weil das sog. Point-on-Wave Verfahren lange erprobt ist.

In einer weiteren bevorzugten Ausführungsform des erfindungsgemäßen Verfahrens wird für die Zeitstempel das Precise Time Protocol verwendet. Dies ist ein Vorteil, weil das sog. Precise Time Protocol (PTP) eine besonders genaue und kostengünstige Möglichkeit bietet, Zeitstempel zu vergeben. Es kann rein mit Software umgesetzt werden, so dass Kosten für zusätzliche Hardware entfallen. Es erreicht bei Softwareimplementierung eine Synchronisation von wenigen µs Genauigkeit, wobei die absolute Genauigkeit von der Art der Implementierung des PTP abhängig ist. Aus der Veröffentlichung "White Paper Präzise Uhrzeitsynchronisation - Der Standard IEEE 1588 Rev. 1.2", herausgegeben von der Universität Reutlingen, ist eine Implementierung des PTP bekannt, mit der eine Genauigkeit von 50µs erzielt werden kann. Die elektromagnetischen Impulse bzw. Teilentladungen werden i.d.R. mit einer Abtastrate von 5kHz aufgelöst. Dies bedeutet einen zeitlichen Abstand zweier Messwerte von 200µs. Bis zu einer Abweichung von 100µs zwischen zentraler und dezentralen Komponenten sollte daher jede TE-Einzelmessung korrekt zugeordnet werden können. Die absolute Genauigkeit der internen Uhren spielt hierbei nur eine untergeordnete Rolle, vielmehr entscheidet die relative Genauigkeit der Zeitstempel zueinander über den Erfolg des erfindungsgemäßen Verfahrens.

Um den Verdrahtungsaufwand zu minimieren, kann das TCP/IP Protokoll für die Ausführung der Zeitsynchronisation sowie für die Übertragung der Sinuscharakteristika verwendet werden, da auch andere Messwerte einer GIS typischerweise bereits über diese Schnittstelle übertragen werden.

In dem erfindungsgemäßen Verfahren werden die Zeitstempel mit einer Genauigkeit von unter 100 µs bestimmt. Dies ist ein Vorteil, weil eine so hohe Genauigkeit eine ausreichend genaue Überlagerung des sinusförmigen Phasenverlaufs mit den Teilentladungssignalen gestattet.

In einer weiteren bevorzugten Ausführungsform des erfindungsgemäßen Verfahrens wird der sinusförmige Phasenverlauf für mehrere Phasen ermittelt, und die Teilentladungssignale werden jeweils einer der mehreren Phasen zugeordnet. Dies ist ein Vorteil, weil z.B. bei einer GIS für das Schalten einer dreiphasigen Hochspannung durch die Unterscheidung der Phasen eine phasenspezifische Erkennung von Teilentladungen ermöglicht wird.

In einer weiteren bevorzugten Ausführungsform des erfindungsgemäßen Verfahrens werden als charakterisierende Phasenunkte die Zeitpunkte von Nulldurchgängen mit positivem Spannungsanstieg verwendet. Dies ist ein Vorteil, weil sich hieraus z.B. zwei charakterisierende Phasenunkte pro 360 Grad Phasenverlauf ergeben, was einfach und zweckmäßig für die Festlegung der Zeitstempel ist.

Ferner stellt sich ausgehend von bisher bekannten Anordnungen zum Erkennen von Teilentladungen bei einem elektrischen Betriebsmittel mittels UHF-Auswertung an die Erfindung die Aufgabe, eine Kombination anzugeben, die vergleichsweise einfach und kostengünstig zur Überwachung einer GIS einsetzbar ist.

Die Erfindung löst diese Aufgabe durch eine Kombination gemäß Anspruch 8. Bevorzugte Ausführungsformen ergeben sich aus den abhängigen Ansprüchen 9 bis 10. Dabei ergeben sich für die erfindungsgemäße Kombination und ihre Ausführungsformen sinngemäß die gleichen Vorteile wie eingangs für das erfindungsgemäße Verfahren erläutert.

Zur besseren Erläuterung der Erfindung zeigt in schematischer Darstellung die
- Figur 1: ein erstes Ausführungsbeispiel der Erfindung, und
- Figur 2: ein zweites Ausführungsbeispiel der Erfindung, und
- Figur 3: ein drittes Ausführungsbeispiel der Erfindung, und
- Figur 4: ein viertes Ausführungsbeispiel der Erfindung, und
- Figur 5: ein fünftes Ausführungsbeispiel der Erfindung, und
- Figur 6: ein sechstes Ausführungsbeispiel der Erfindung, und
- Figur 7: ein siebtes Ausführungsbeispiel der Erfindung, und
- Figur 8: ein achtes Ausführungsbeispiel einer erfindungsgemäßen Anordnung.

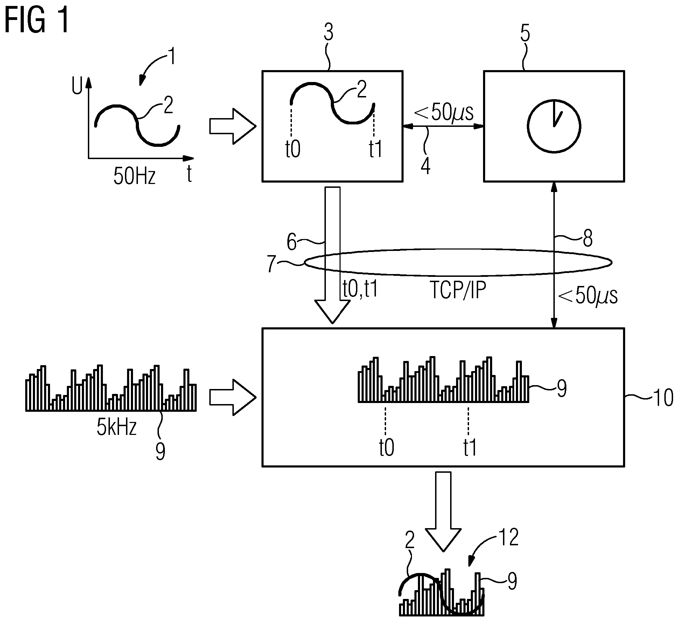

Die Figur 1 zeigt in schematischer Darstellung ein erstes Ausführungsbeispiel des erfindungsgemäßen Verfahrens. Es wird mittels einer Spannungsmessanordnung 3 zentral ein sinusförmiger Phasenverlauf beziehungsweise Spannungsverlauf 2 einer 50 Hz Spannung gemessen. Dabei bezeichnet U die Amplitude der Spannung. Mittels einer nicht dargestellten Referenzanordnung wird in dem Phasenverlauf 2 mindestens ein charakterisierender Phasenpunkt ermittelt. In diesem Beispiel werden die Phasenpunkte T0 und T1 derart ermittelt, dass bei einem Nulldurchgang mit positivem Anstieg die Phasenpunkte gesetzt werden. In dem dargestellten Beispiel befinden sich die Phasenpunkte T0 und T1 jeweils bei 0 und 360° des Spannungsverlaufs. Die Spannungsmessanordnung 3 ist über eine Datenkommunikation 4 mit einer Referenzanordnung 5 verbunden. Dabei handelt es sich um einen Zeitserver, der das Precise Time Protocol verwendet. Die Referenzanordnung 5 stellt mit einer Gangabweichung von weniger als 50µs zur Referenzuhr über die Kommunikationsverbindung 4 Zeitstempel für die beiden charakterisierenden Phasenpunkte T0 und T1 zur Verfügung. Die auf diese Weise mit einem Zeitstempel versehenen Phasenpunkte T0 und T1 werden über eine Datennachricht 6, die über ein Kommunikationsnetzwerk 7 z.B. mit dem TCP/IP-Protokoll verschickt wird, zu einer Auswertungsanordnung 10 übermittelt. Beispielhaft wird im linken Teil der Abbildung ein elektromagnetisches Signal 9 mit einer Auflösung von 5 kHz mittels einer Sensoreinrichtung (nicht dargestellt) an einer vorbestimmten Position des Betriebsmittels dezentral erfasst. Das elektromagnetische Signal 9 wird an die Auswertungsanordnung 10 übermittelt. Mittels einer Zeitstempelanordnung, in diesem Beispiel zusammengefasst mit der Referenzanordnung 5, wird auch für das elektromagnetische Signal 9 ein Zeitstempel über eine Datenkommunikation 8 mit einer Gangabweichung von weniger als 50µs zur Referenzuhr bereitgestellt. Innerhalb der Auswertungsanordnung 10 liegen nun einerseits die charakteristischen Phasenpunkte T0 und T1 mit ihren entsprechenden Zeitstempeln vor und andererseits das gemessene elektromagnetische Signal 9, das ebenfalls mit einem Zeitstempel markiert wurde. Hierdurch können die Zeitstempel für die Phasenpunkte T0, T1 und das elektromagnetische Signal berücksichtigt werden, um in einem weiteren Schritt überlagert zu werden. Es ergibt sich eine Überlagerung 12 des sinusförmigen Phasenverlaufs 2, der vormals gemessenen Eingangsspannung des Betriebsmittels, mit dem elektromagnetischen Signal 9, welches mittels der Sensoreinrichtung gemessen wurde. Anhand dieses überlagerten Diagramms 12, häufig als so genanntes Point-on-Wave Verfahren bezeichnet, können Teilentladungen erkannt und durch den Zusammenhang mit dem Spannungsverlauf Fehlerursachen ermittelt werden.

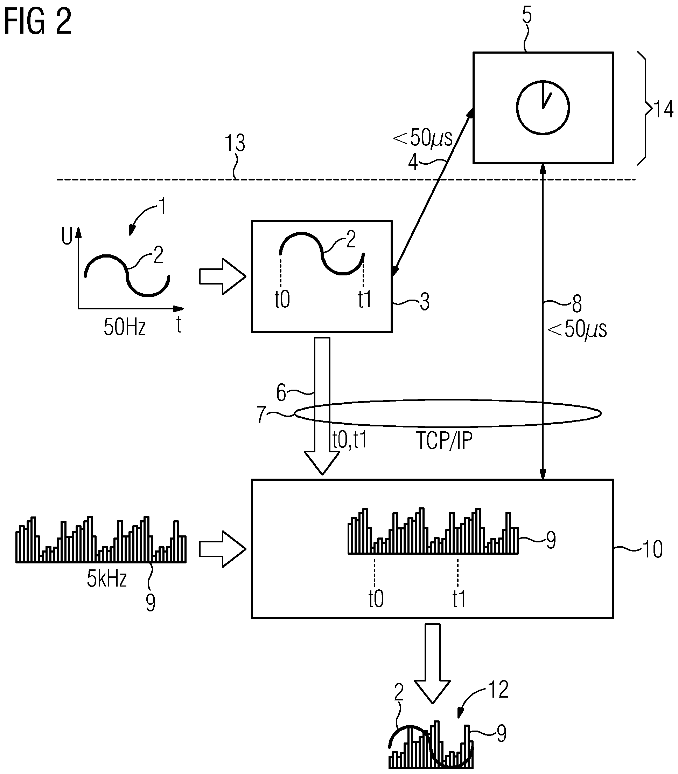

In dem zweiten Ausführungsbeispiel gemäß Figur 2 wird im Unterschied zum Verfahren gemäß Figur 1 die Referenzanordnung 3 bzw. die Zeitstempelanordnung nicht mehr in direkter räumlicher Nähe zu der Spannungsmessanordnung 3 und der Auswertungsanordnung 10 vorgesehen. Vielmehr wird der externe Zeitserver 5 in einem Bereich 14, die räumliche Trennung ist dabei durch eine gestrichelte Linie 13 angedeutet, vorgesehen. Der Bereich 14 kann beispielsweise ein externes Rechenzentrum oder eine Website sein, die über Datenkommunikationsverbindungen 4, 8 über ein herkömmliches Internetprotokoll mit den weiteren Komponenten Spannungsmessanordnung 3 und Auswertungsanordnung 10 kommuniziert. Dieses Ausführungsbeispiel bietet den Vorteil, dass für eine Vielzahl von lokal vorgesehenen Messverfahren beziehungsweise Anordnungen ein einziger Zeitserver an einer zentralen Position vorgesehen werden kann. Dies spart Kosten ein und ermöglicht außerdem eine problemlose Wartung und Updates für die Referenzanordnung beziehungsweise Zeitstempelanordnung 5.

Andererseits muss sichergestellt sein, dass die Datenkommunikationsverbindungen 4, 8 ausreichend genau die internen Uhren bzw. die entsprechenden Zeitstempel vergleichen können. In der Regel ist es erforderlich, eine Gangabweichung von unter 50µs einzuhalten, damit die internen Uhren der Einrichtungen 3,10 eine Gangabweichung von höchstens 100µs einhalten.

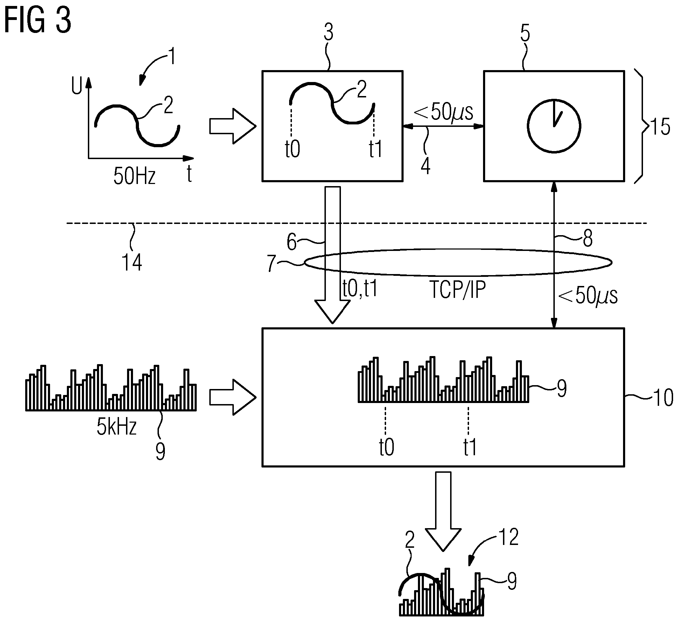

Die Figur 3 zeigt ein drittes Ausführungsbeispiel der Erfindung. Dabei werden der Zeitserver 3 mit Referenzanordnung und Zeitstempelanordnung sowie die Spannungsmessanordnung in einem Bereich 15 vorgesehen, der durch die gestrichelte Linie 14 angedeutet wird. In diesem Ausführungsbeispiel liegen nur die Auswertungsanordnung 10 sowie die nicht dargestellten Sensoreinrichtungen direkt an dem zu überwachenden Betriebsmittel vor. Die Spannungsmessung sowie die Zeitstempel werden an einem räumlich nicht in direkter Nähe vorgesehenen Ort erzeugt.

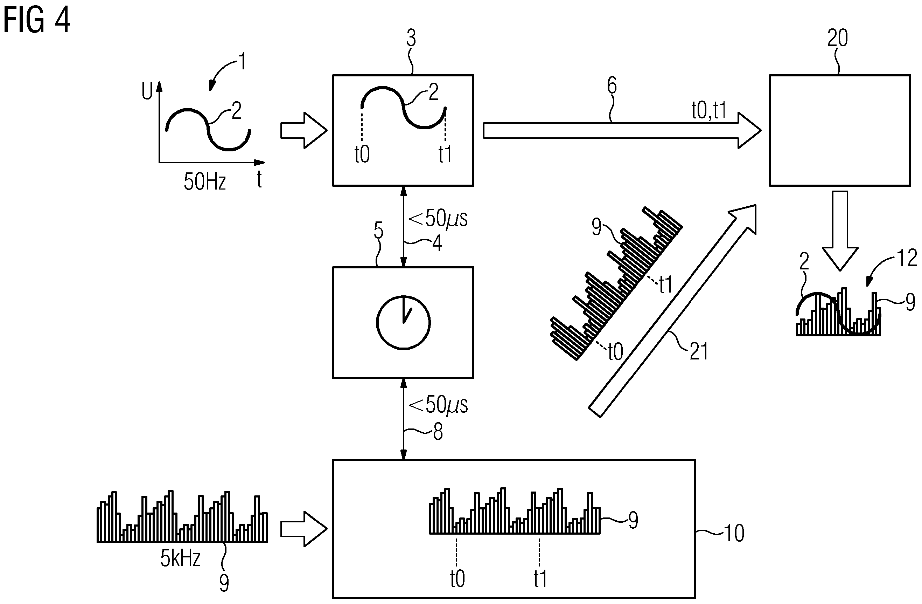

In dem Ausführungsbeispiel gemäß Figur 4 erfolgt die Überlagerung 12 nicht mittels der Auswertungsanordnung 10, sondern vielmehr stellt die Auswertungsanordnung 10 die elektromagnetischen Signale 9 mit markierten charakteristischen Phasenpunkten T0, T1 einer Überlagerungseinrichtung 20 zur Verfügung. Diese Überlagerungseinrichtung 20 erzeugt die Überlagerung 12.

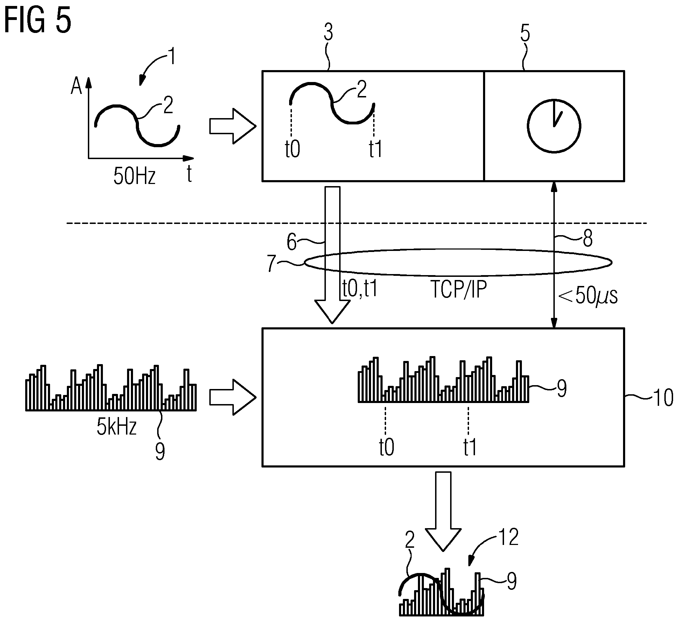

In dem Ausführungsbeispiel gemäß Figur 5 ist die Referenzanordnung 5 beziehungsweise die Zeitstempelanordnung direkt an die Spannungsmessanordnung 3 angeschlossen. Hierdurch entfällt die Kommunikationsverbindung 4, was aufgrund der noch stärker verminderten Gangabweichungen die Genauigkeit der Auswertung im Verfahren steigert. Die Gangabweichung der Spannungsmessanordnung 3 und der Auswertungsanordnung 10 hängt nur von der Kommunikationsverbindung 8 ab. Bei ansonsten gleicher Synchronität von 50 µs kann somit die Genauigkeit der Auswertung im Verfahren steigen. Im Umkehrschluss kann für gleichbleibende Genauigkeit im Verfahren die Gangabweichung der Komponenten 5 und 10 auf 100µs abfallen.

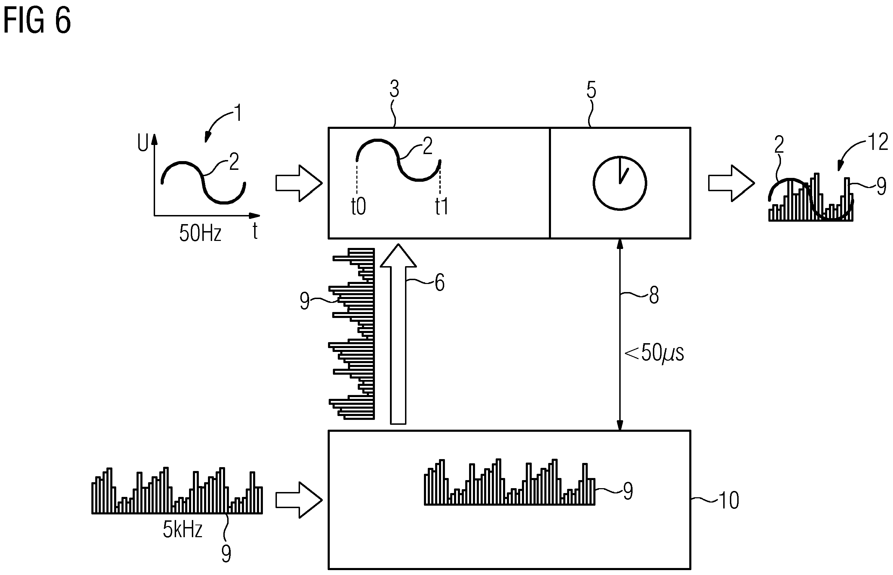

Bei dem Ausführungsbeispiel gemäß Figur 6 wird eine kombinierte Anordnung eingesetzt, die die Spannungsmessanordnung 3 zusammen mit der Referenzanordnung 5 beziehungsweise Zeitstempelanordnung zusammenfasst. Außerdem ist die Anordnung ausgebildet, auch die Überlagerung 12 zu erzeugen. Hierfür erhält die Anordnung das mit einem Zeitstempel versehene elektromagnetische Signal 9 von der Auswerteeinrichtung 10. Dieses Setup hat den Vorteil, dass lediglich die Sensoreinrichtungen tatsächlich lokal vorgesehen werden müssen, während für die gesamte Anlage oder elektrische Installation zentral eine Anordnung die Auswertung bereitstellen kann.

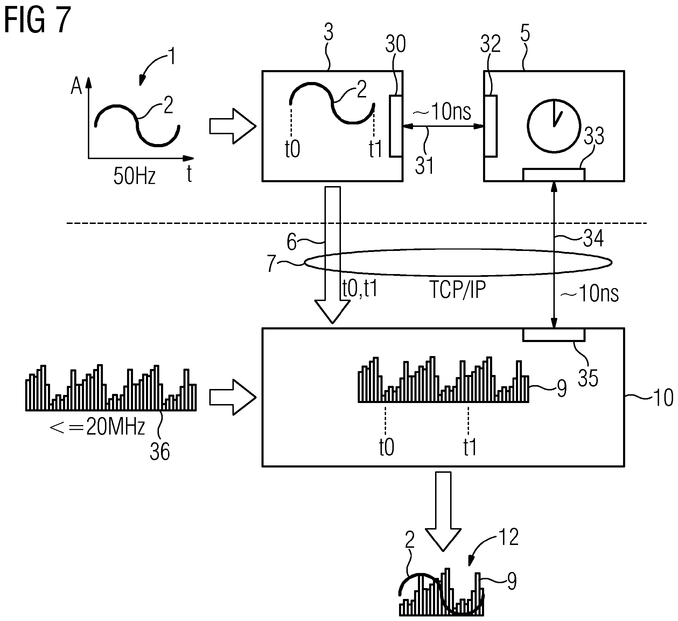

Beim Ausführungsbeispiel gemäß Figur 7 werden zur Steigerung der Genauigkeit der Synchronisation beziehungsweise der Zeitstempel hardwarebasierte Lösungen eingesetzt. Hierbei sorgt ein für die Zeitsynchronisation mittels PTP ausgebildeter Schaltkreis für eine Synchronisation von Signalen im Nanosekundenbereich. Hierdurch können noch höhere Abtastraten erfolgreich synchronisiert werden, was die Genauigkeit der Überlagerung 12 weiter steigert. Um dies zu erreichen, ist bei einer Vorgehensweise ähnlich zu Figur 1 jeweils eine hardwarebasierte Komponente 30, 32, 33, 35 an der Spannungsmessanordnung 3, der Referenzanordnung 5, und der Auswertungsanordnung 10 vorgesehen.

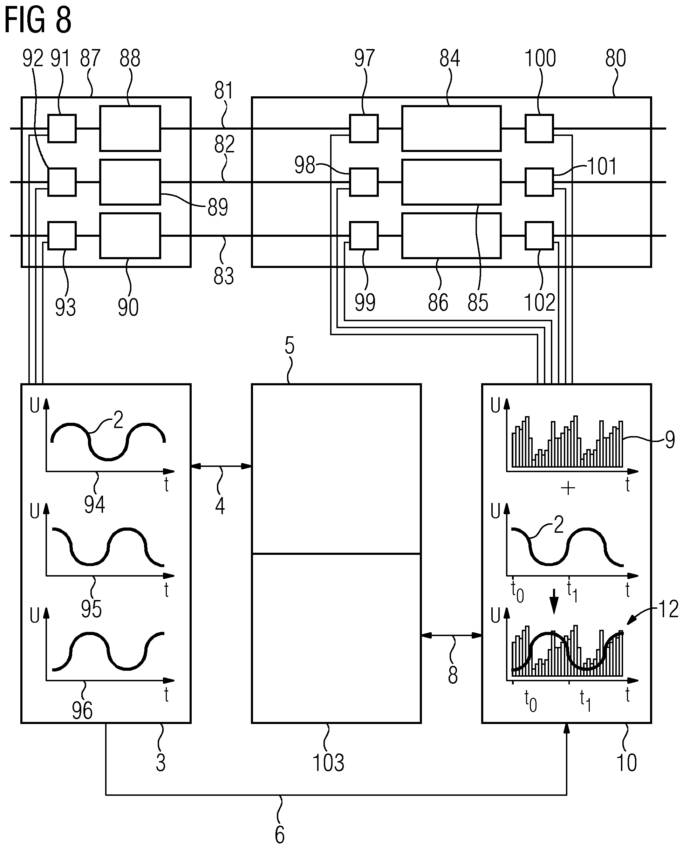

Bei dem Ausführungsbeispiel gemäß Figur 8 ist eine gasisolierte Schaltanlage 80 gezeigt. Sie hat für jede der drei Phasen 81,82,83 einen eigenen Leistungsschalter 84,85,86 vorgesehen. Jeweils vor und nach dem jeweiligen Leistungsschalter 84,85,86 sind Sensoreinrichtungen 97-102 bzw. interne Antennen vorgesehen, die zur dezentralen Erfassung elektromagnetischer Signale ausgebildet sind. Weiterhin ist ein Spannungswandler 87 mit je einer Wandlereinrichtung 88,89,90 für jede Phase 81,82,83 vorgesehen. Im Spannungswandler 89 ist für jede Phase 81,82,83 ein Spannungssensor 91,92,93 vorgesehen, der mit einer Spannungsmessanordnung 3 zur zentralen Ermittlung eines sinusförmigen Phasenverlaufs 2 einer elektrischen Spannung vorgesehen ist. Für jede Phase 81,82,83 wird folglich ein Spannungsverlauf gemessen.

In der Spannungsmessanordnung 3 wird für jede der Phasen ein Phasenverlauf 2 der Spannung ermittelt, hier schematisch durch die Diagramme 94,95,96 dargestellt. Eine Referenzanordnung 5 ist vorgesehen, um zwei den Phasenverlauf charakterisierende Phasenpunkte mit einem Zeitstempel (t0,t1) zu markieren. Dabei handelt es sich beispielsweise um Zeitpunkte t0,t1 im Spannungsverlauf 2 im Diagramm 94 einer der Phasen 81,82,83, an denen ein Nulldurchgang mit positiver Ableitung der Spannung (Spannungsanstieg) vorliegt.

Die Sensoreinrichtungen 97-102 übermitteln elektromagnetische Signale an eine Auswertungsanordnung (10). Beispielhaft ist ein Verlauf von elektromagnetischen Signalen 9 nach der Zeit aufgetragen, der sich aus einer der Messungen einer Sensoreinrichtung 97-102 ergibt. Die elektromagnetischen Signale 9 erhalten von einer Zeitstempelanordnung 103 jeweils einem Zeitstempel.

Die Auswertungsanordnung 10 erhält, vereinfacht und nur für eine der drei Phasen dargestellt, die mit Zeitstempeln versehenen elektromagnetischen Signale 9 und den Phasenverlauf 2 mit den Phasenpunkten t0,t1, die ebenfalls durch Zeitstempel markiert sind. Die Auswertungsanordnung 10 ist ausgebildet, in den elektromagnetischen Signalen 9 Teilentladungssignale festzustellen und die Zeitstempel der charakterisierenden Phasenpunkte t0,t1 und die Zeitstempel der Teilentladungssignale bei einer Überlagerung 12 des sinusförmiger Phasenverlaufs 9 zu berücksichtigen. Diese Überlagerung 12 ermöglicht es, eine Ursache der jeweiligen Teilentladung zu erkennen.

## Patentansprüche

1. Verfahren zum Erkennen von Teilentladungen bei einem elektrischen Betriebsmittel (80), bei dem
mittels mehrerer Sensoreinrichtungen (97-102) elektromagnetische Signale (9) an verschiedenen Positionen des Betriebsmittels (80) dezentral erfasst werden,
wobei mittels einer Spannungsmessanordnung (3) für eine elektrische Spannung zentral ein sinusförmiger Phasenverlauf (2) ermittelt wird, und
mittels einer Referenzanordnung (5) mindestens ein den Phasenverlauf charakterisierender Phasenpunkt mit einem Zeitstempel (t0,t1) versehen wird, und
mittels einer Zeitstempelanordnung (103) die elektromagnetischen Signale (9) jeweils mit einem Zeitstempel versehen werden, und
mittels einer Auswertungsanordnung (10) in den elektromagnetischen Signalen (9) jeweils ein Teilentladungssignal festgestellt wird, und
mittels der Auswertungsanordnung (10) der mindestens eine Zeitstempel (t0,t1) des charakterisierenden Phasenpunkts und die Zeitstempel der Teilentladungssignale bei einer Überlagerung (12) des sinusförmigen Phasenverlaufs (2) mit den Teilentladungssignalen berücksichtigt werden,
wobei die elektrische Spannung (U) zentral an einem Spannungswandler (87-90) für das Betriebsmittel (80) erfasst wird,
wobei als Betriebsmittel eine gasisolierte elektrische Schalt-, anlage (80) verwendet wird und
wobei die Zeitstempel mit einer Genauigkeit von unter 100 µs bestimmt werden.

2. Verfahren nach Anspruch 1, **dadurch gekennzeichnet, dass** als Sensoreinrichtungen interne und/oder externe Antennen (97-101) zum Empfang von elektromagnetischen Signalen (9) verwendet werden.

3. Verfahren nach einem der vorhergehenden Ansprüche, **dadurch gekennzeichnet, dass** die Überlagerung (12) jeweils ausgewertet wird, um eine Ursache der jeweiligen Teilentladung zu erkennen.

4. Verfahren nach einem der vorhergehenden Ansprüche, **dadurch gekennzeichnet, dass** für die Überlagerung (12) jeweils ein Point-on-Wave Verfahren eingesetzt wird.

5. Verfahren nach einem der vorhergehenden Ansprüche, **dadurch gekennzeichnet, dass** für die Zeitstempel (t0,t1) das Precise Time Protocol (PTP) verwendet wird.

6. Verfahren nach einem der vorhergehenden Ansprüche, **dadurch gekennzeichnet, dass** der sinusförmige Phasenverlauf (2) für mehrere Phasen (81,82,83) ermittelt wird, und dass die Teilentladungssignale jeweils einer der mehreren Phasen (81,82,83) zugeordnet werden.

7. Verfahren nach einem der vorhergehenden Ansprüche, **dadurch gekennzeichnet, dass** als charakterisierende Phasenpunkte die Zeitpunkte von Nulldurchgängen mit positivem Spannungsanstieg (t0,t1) verwendet werden.

8. Kombination aus einem elektrischen Betriebsmittel (80) und einer Anordnung zum Erkennen von Teilentladungen bei dem elektrischen Betriebsmittel (80), aufweisend
- mehrere Sensoreinrichtungen (97-102), die zur dezentralen Erfassung elektromagnetischer Signale (9) an verschiedenen Positionen des Betriebsmittels (80) ausgebildet sind,
- eine Spannungsmessanordnung (3) zur zentralen Ermittlung eines sinusförmigen Phasenverlaufs (2) einer elektrischen Spannung, und
- eine Referenzanordnung (5), die zum Versehen mindestens eines den Phasenverlauf charakterisierenden Phasenpunkts mit einem Zeitstempel (t0,t1) ausgebildet ist, und
- eine Zeitstempelanordnung (103) zum Versehen der elektromagnetischen Signale (9) mit jeweils einem Zeitstempel, und
- eine Auswertungsanordnung (10), die ausgebildet ist, in den elektromagnetischen Signalen (9) jeweils ein Teilentladungssignal festzustellen und den mindestens einen Zeitstempel des charakterisierenden Phasenpunkts (t0,t1) und die Zeitstempel der Teilentladungssignale bei einer Überlagerung (12) des sinusförmigen Phasenverlaufs (2) mit den Teilentladungssignalen zu berücksichtigen,
wobei die Spannungsmessanordnung (3) ausgebildet ist, die elektrische Spannung zentral an einem Spannungswandler (87) für das Betriebsmittel (80) zu erfassen,
wobei die Zeitstempel mit einer Genauigkeit von unter 100 µs bestimmt werden, **dadurch gekennzeichnet, dass** das Betriebsmittel eine gasisolierte elektrische Schaltanlage (80) ist.

9. Kombination nach Anspruch 8, **dadurch gekennzeichnet, dass** die Sensoreinrichtungen interne und/oder externe Antennen (97-102) zum Empfang von elektromagnetischen Signalen aufweisen.

10. Kombination nach einem der Ansprüche 8 bis 9, **dadurch gekennzeichnet, dass** die Auswertungseinrichtung (80) ausgebildet ist, die Überlagerung (12) jeweils auszuwerten, um eine Ursache der jeweiligen Teilentladung zu erkennen.

## Claims

1. Method for detecting partial discharges in an item of electrical equipment (80) in which
electromagnetic signals (9) are recorded in a decentralized manner at different positions of the item of equipment (80) by means of a plurality of sensor apparatuses (97-102),
wherein
a sinusoidal phase profile (2) is centrally ascertained for a voltage by means of a voltage measuring arrangement (3), and
at least one phase point characterizing the phase profile is provided with a time stamp (t0, t1) by means of a reference arrangement (5), and
the electromagnetic signals (9) are each provided with a time stamp by means of a time stamp arrangement (103), and
a partial discharge signal is determined in each of the electromagnetic signals (9) by means of an evaluation arrangement (10), and
the at least one time stamp (t0, t1) of the characterizing phase point and the time stamps of the partial discharge signals are taken into consideration by means of the evaluation arrangement (10) when the sinusoidal phase profile (2) is superposed (12) with the partial discharge signals,
wherein the voltage (U) is centrally recorded at a voltage transformer (87-90) for the item of equipment (80),
wherein the item of equipment used is a gas-insulated electrical switchgear unit (80), and
wherein the time stamps are determined to within a margin of accuracy of less than 100 µs.

2. Method according to Claim 1, **characterized in that** the sensor apparatuses used are internal and/or external antennas (97-101) for receiving electromagnetic signals (9).

3. Method according to either of the preceding claims, **characterized in that** the superposition (12) is evaluated in each case so as to detect a cause of the respective partial discharge.

4. Method according to one of the preceding claims, **characterized in that** a point-on-wave method is used in each case for the superposition (12).

5. Method according to one of the preceding claims, **characterized in that** the precise time protocol (PTP) is used for the time stamps (t0, t1).

6. Method according to one of the preceding claims, **characterized in that** the sinusoidal phase profile (2) is ascertained for a plurality of phases (81, 82, 83), and **in that** the partial discharge signals are each assigned to one of the plurality of phases (81, 82, 83).

7. Method according to one of the preceding claims, **characterized in that** the characterizing phase points used are the times of zero-crossings with a positive voltage rise (t0, t1).

8. Combination of an item of electrical equipment (80) and an arrangement for detecting partial discharges in the item of electrical equipment (80), having
- a plurality of sensor apparatuses (97-102), which are designed for recording, in a decentralized manner, electromagnetic signals (9) at different positions of the item of equipment (80),
- a voltage measuring arrangement (3) for centrally ascertaining a sinusoidal phase profile (2) of a voltage, and
- a reference arrangement (5), which is designed to provide at least one phase point characterizing the phase profile with a time stamp (t0, t1), and
- a time stamp arrangement (103) for providing the electromagnetic signals (9) with a time stamp in each case, and
- an evaluation arrangement (10), which is designed to determine a partial discharge signal in each of the electromagnetic signals (9), and to take into consideration the at least one time stamp of the characterizing phase point (t0, t1) and the time stamps of the partial discharge signals when the sinusoidal phase profile (2) is superposed (12) with the partial discharge signals,
wherein the voltage measuring arrangement (3) is designed to centrally ascertain the voltage at a voltage transformer (87) for the item of equipment (80),
wherein the time stamps are determined to within a margin of accuracy of less than 100 µs, **characterized in that** the item of equipment is a gas-insulated electrical switchgear unit (80).

9. Combination according to Claim 8, **characterized in that** the sensor apparatuses have internal and/or external antennas (97-102) for receiving electromagnetic signals.

10. Combination according to either of Claims 8 and 9, **characterized in that** the evaluation apparatus (80) is designed to evaluate the superposition (12) in each case so as to detect a cause of the respective partial discharge.

## Revendications

1. Procédé de détection de décharges partielles sur un équipement (80) électrique, dans lequel on détecte, de manière décentralisée, au moyen de plusieurs dispositifs (97-102) capteurs, des signaux (9) électromagnétiques en diverses positions de l'équipement (80),
dans lequel,
au moyen d'un agencement (3) de mesure de la tension, on détermine, de manière centralisée, pour une tension électrique une courbe (2) sinusoïdale de phase et,
au moyen d'un agencement (5) de référence, on munit d'une estampille (t0, t1) temporelle au moins un point de phase caractérisant la courbe de phase et,
au moyen d'un agencement (103) d'estampille temporelle, on munit les signaux (9) électromagnétiques respectivement d'une estampille temporelle et,
au moyen d'un dispositif (10) d'évaluation, on détermine respectivement un signal de décharge partielle dans les signaux (9) électromagnétiques et,
au moyen du dispositif (10) d'évaluation, on prend en compte la au moins une estampille (t0, t1) temporelle du point de phase caractérisant et l'estampille temporelle des signaux de décharge partielle, lors d'une superposition (12) de la courbe (2) sinusoïdale de phase avec les signaux de décharges partielle,
dans lequel on détecte, de manière centralisée, pour l'équipement (80), la tension (U) électrique sur un convertisseur (87-90) de tension,
dans lequel on utilise, comme équipement, une installation (80) électrique de coupure à isolation par du gaz, et
dans lequel on détermine les estampilles temporelles avec une précision inférieure à 100 µs.

2. Procédé suivant la revendication 1, **caractérisé en ce que** l'on utilise, comme dispositifs capteurs, des antennes (97-101) internes et/ou externes pour la réception de signaux (9) électromagnétiques.

3. Procédé suivant l'une des revendications précédentes, **caractérisé en ce que** l'on évalue la superposition (12) respectivement, pour reconnaître une cause de la décharge partielle respective.

4. Procédé suivant l'une des revendications précédentes, **caractérisé en ce que** l'on utilise, pour la superposition (12), respectivement un procédé point on wave.

5. Procédé suivant l'une des revendications précédentes, **caractérisé en ce que** l'on utilise, pour les estampilles (t0, t1) temporelles, le precise time protocol (PTP).

6. Procédé suivant l'une des revendications précédentes, **caractérisé en ce que** l'on détermine la courbe (2) sinusoïdale de phase pour plusieurs phases (81, 82, 83), et **en ce que** l'on associe les signaux de décharge partielle a respectivement l'une des plusieurs phases (81, 82, 83).

7. Procédé suivant l'une des revendications précédentes, **caractérisé en ce que** l'on utilise, comme points de phase caractérisants, les instants de passage par zéro avec croissance (t0, T1) positive de la tension.

8. Combinaison d'un équipement (80) électrique et d'un agencement de détection de décharges partielles sur l'équipement (80) électrique, comportant
- plusieurs dispositifs (97-102) capteurs, qui sont constitués pour la détection, de manière décentralisée, de signaux (9) électromagnétiques en diverses positions de l'équipement (80),
- un agencement (3) de mesure de la tension pour la détermination, de manière centralisée, d'une courbe (2) sinusoïdale de phase d'une tension électrique, et
- un agencement (5) de référence, qui est constitué pour munir d'une estampille (t0, t1) temporelle au moins un point de phase caractérisant la courbe de phase, et
- un agencement (103) d'estampille temporelle pour munir les signaux (9) électromagnétiques respectivement d'une estampille temporelle, et
- un dispositif (10) d'évaluation, qui est constitué pour déterminer, dans les signaux (9) électromagnétiques, respectivement un signal de décharge partielle et, pour prendre en compte la au moins une estampille temporelle du point (t0, t1) de phase caractérisant et l'estampille temporelle des signaux de décharge partielle, lors d'une superposition (12) de la courbe (2) sinusoïdale de phase avec les signaux de décharge partielle,
dans lequel l'agencement (3) de mesure de la tension est constitué pour détecter, de manière centralisée, pour l'équipement (80) la tension électrique sur un convertisseur (87) de tension,
dans lequel on détermine les estampilles temporelles avec une précision inférieure à 100 µs, **caractérisée en ce que** l'équipement est une installation (80) électrique de coupure à isolation par du gaz.

9. Combinaison suivant la revendication 8, **caractérisée en ce que** les dispositifs capteurs ont des antennes (97-102) internes et/ou externes pour la réception de signaux électromagnétiques.

10. Combinaison suivant l'une des revendications 8 à 9, **caractérisée en ce que** le dispositif (80) d'évaluation est constitué pour évaluer la superposition (12) respectivement, afin de reconnaître une cause de la décharge partielle respective.
